# EUROPÄISCHE PATENTSCHRIFT

(11) **EP 2 033 231 B1**
(45) Veröffentlichungstag und Bekanntmachung des Hinweises auf die Patenterteilung: **24.10.2012**
(21) Anmeldenummer: 07725908.3
(22) Anmeldetag: 08.06.2007
(51) Int. Cl.: F24J 2/20, F24J 2/46, H01L 31/048, H01L 31/058, H01L 31/042, F24J 2/24, H01L 31/052

(54) **Solarelement mit Temperiereinrichtung**
Solar element with temperature control device
Élément solaire avec dispositif de régulation de température

(30) Priorität: 13.06.2006 DE 102006027629
(43) Veröffentlichungstag der Anmeldung: 11.03.2009
(73) Patentinhaber: Bihler, Willi, 87640 Biessenhofen-Altdorf (DE)
(72) Erfinder: Bihler, Willi, 87640 Biessenhofen-Altdorf (DE)
(74) Vertreter: Knoop, Philipp
(86) Internationale Anmeldenummer: PCT/EP2007/005063
(87) Internationale Veröffentlichungsnummer: WO 2007/144113

(56) Entgegenhaltungen:
- DE-A1- 4 424 801
- DE-A1- 10 322 048
- DE-A1- 19 651 226
- DE-A1- 19 958 053
- JP-A- 2000 114 574
- JP-A- 2003 318 432
- US-A- 6 080 927

## Beschreibung

Die vorliegende Erfindung betrifft ein Solarelement bestehend aus Solarzellenträger, Rahmen und Temperiereinrichtung, wobei der Rahmen wenigstens eine sonnenabgewandte Seite des Solarelements überdeckend ausgebildet ist und wobei die Temperiereinrichtung mehrere, miteinander verbundene Hohlräume aufweist, wobei die Hohlräume als voneinander beabstandete, miteinander verbundene Kanäle ausgebildet sind, die mit ihrer offenen Seite an den Solarzellenträger grenzend ausgebildet sind, sowie ein Verfahren zur Herstellung des Solarelements, und dessen Verwendung.

Solarelemente bestehen üblicherweise aus einem rahmengefaßten Solarzellenträger, wobei letzterer in der Regellagenförmig aufgebaut ist. Dem Sonnenlicht zugewandt befindet sich eine Glasschicht, in der Regel Einscheiben-Sicherheitsglas, gefolgt von einer transparente Kunststoffschicht aus Ethylen-Vinylacetat (EVA), in die die eigentlichen Solarzellen, beispielsweise Photovoltaikzellen, eingebettet sind. Die mono- oder polykristallinen Solarzellen sind hierbei durch Lötbändchen elektrisch miteinander verschaltet. An die EVA-Schicht schließt sich eine Rückseitenkaschierung aus einer witterungsfesten Kunststoffverbundfolie an, die in der Regel aus Polyester und Polyvinylfluorid besteht, beispielsweise eine Tedlar-Folie. Solche Solarzellenträger werden mit der optisch aktiven Seite nach unten gefertigt. Auf ein Glas wird eine zugeschnittene EVA-Folie gelegt, darauf kommen die Solarzellen, die mittels Lötbändchen zu einzelnen Strängen verbunden und diese danach weiter elektrisch verkabelt werden. Eine weitere zugeschnittene EVA-Folie sowie die Tedlar-Folie schließen die Schichtung ab. Es folgt die Laminierung des so vorbereiteten Moduls bei Unterdruck und etwa 150°C, bei dem eine Polymerisationsreaktion in der EVA-Folie zu einem dreidimensional vernetzten, klaren und fest mit der Tedlarfolie und dem Glas verbundenen Kunststoff führt, der die Solarzellen umschließt. Abschließend wird der Solarzellenträger mittels eines Aluminiumrahmens gerahmt. Dieser Rahmen bedeckt nur die Kanten des Solarzellenträgers und lässt dessen Boden- und Sonnenseite zum allergrößten Teil frei. Das so vorbereitete Solarelement wird verpackt, verschickt und beispielsweise auf einem Hausdach zusammen mit weiteren Solarelementen montiert.

Solche Solarelemente sind bruchgefährdet, insbesondere in Gebieten mit einer hohen winterlichen Schneelast, die bis zu 700 kg/m² betragen kann. Die auf Hausdächem montierten Solarelemente sind in der Regel auf zwei, mehrere Solarelemente miteinander verbindenden Montageschienen angeordnet, wobei letztere mittels dachpfannenumgreifender Dachhaken an der Tragkonstruktion des Daches befestigt sind. Aufgrund dieser Anordnung biegen sich die Solarelemente bei höherer Schneelast leicht durch und können brechen. Bei dem Versuch, die Schneelast der auf Dächern montierten Solarelemente durch Abfegen zu verringern, kommt es immer wieder zu tödlich endenden Abstürzen.

Dadurch, dass der Aluminiumrahmen die sonnenabgewandte Seite des Solarzellenträgers zum allergrößten Teil unbedeckt lässt, wird zwar dessen mechanische Stabilität nicht wesentlich erhöht, jedoch mit Vorteil dessen Hinterlüftung ermöglicht. Diese verbessert den stark temperaturabhängigen Wirkungsgrad der Solarzellen, da Luft an die im Sonnenlicht erhitzten Solarelemente herantreten und Wärme abführen kann. Bei hohen Außentemperaturen ist die Kühlwirkung einer solchen Hinterlüftung jedoch entsprechend gering und die Solarzellen weisen dann Betriebstemperaturen von etwa 70°C mit einer um etwa 20% gegenüber den Herstellerangaben reduzierten Leistungsfähigkeit auf.

JP 2000 11 4574 und DE 298 10 238 U1 schlagen daher vor, auf der sonnenabgewandten Seite des Solargellenträgers Kühlkörper vorgesehen.

Die DE 103 22 048 A1 offenbart eine Vorrichtung zur Gewinnung von thermischer und elektrischer Energie aus Sonnenenergie, deren Rahmen einen Solarzellenträger umgreift, wobei der Rahmen Kanäle für Kühlmittel aufweist, die mit ihrer offenen Seite an ein Solarmodul grenzen.

Nachteilig an dieser Erfindung ist, dass sie umständlich herzustellen und größeren Schneelasten nicht gewachsen ist.

Es ist daher Aufgabe der Erfindung, ein bei hoher mechanischer Stabilität und Temperierleistung einfach herzustellendes und aufgebautes Solarelement, ein Herstellverfahren hierfür sowie dessen Verwendung anzugeben.

Die gegenständliche Aufgabe wird dadurch gelöst, dass die Kanäle aus wenigstens einem Formteil, insbesondere Kunststoffformteil, gebildet sind und wobei der Rahmen Armierungen aufweist, vorzugsweise stabförmige Armierungen, die in überwiegend paralleler Richtung zu den Kanälen zwischen diesen angeordnet sind und wobei Solarzellenträger, Rahmen und Temperiereinrichtung einstückig ausgebildet sind. Dadurch, dass der Rahmen eine sonnenabgewandte Seite des Solarelements überdeckt, wird mit Vorteil eine hohe mechanische Stabilität erreicht. Die auf diese Weise gebildete mechanische Unterstützung führt dazu, daß auftretende Belastungen, beispielsweise in Form von hohen Schneelasten, nicht mehr zu Brüchen der Solarelemente führen, da diese vom Rahmen flächig gestützt werden. Ist die Temperiereinrichtung ein integraler Bestandteil des Rahmens, und sind Solarzellenträger, Rahmen und Temperiereinrichtung einstückig ausgebildet, ergibt sich eine einfache Handhabung des erfindungsgemäßen Solarelements. Das Vorsehen einer Temperiereinrichtung als untrennbarer und integraler Bestandteil des Rahmens vereinfacht Aufbau und Herstellung der erfindungsgemäßen Solarelemente deutlich. Der Rahmen schützt die integrierte Temperiereinrichtung vor Umwelteinflüssen oder Vandalismus und erlaubt die Verwendung handelsüblicher, fertig laminierter Solarzellenträger ohne weitere Modifikationen. Sind die Kanäle aus wenigstens einem Formteil, insbesondere Kunststoffformteil, gebildet, ergibt sich der Vorteil der einfachen Herstell- und Weiterverarbeitbarkeit des Formteils, insbesondere als Kunststoffformteil auch der des geringen Gewichts, der hohen Verschleißfestigkeit und langen Standzeit. Das Formteil mit den Kanälen kann aus demselben Material wie der Rahmen oder einem anderen gefertigt sein. Die Kanalstruktur ist einfach und kostengünstig über Tiefziehen eines in der Größe an ein gewünschten Solarzellenträger angepasstes rechteckiges Formteil aus beispielsweise Kunststoff herstellbar. Weist der Rahmen Armierungen auf, vorzugsweise stabförmige Stahlarmierungen, wobei die Armierungen in überwiegend paralleler Richtung zu den Kanälen zwischen diesen angeordnet sind, so ist vorteilhafterweise eine mechanische Verstärkung eines erfindungsgemäßen Solarelements verwirklicht. Die Anordnung der Armierungen zwischen den Kanälen verstärkt deren Wandung ohne weiteren Platzbedarf. Hierdurch kann Material beim Rahmen eingespart und das erfindungsgemäße Solarelement geringer dimensioniert werden.

In Ausgestaltung der Erfindung ist vorgesehen, dass die Kanäle überwiegend parallel ausgebildet sind, und an ihren Stirnseiten über einen gemeinsamen Zulauf und einen gemeinsamen Ablauf miteinander verbunden ausgebildet sind. Diese Ausgestaltung erlaubt mit großem Vorteil eine effektive Temperierung der Solarzellen. Die Kanäle verlaufen erfindungsgemäß jeweils unterhalb einer Reihe der im Solarzellenträger reihenförmig angeordneten Solarzellen. Da erfindungsgemäß der Sölarzellenträger direkt an die Kanäle grenzt, ist der Wärmeübergang von den Solarzellen in das Temperiermittel leicht und effizient. Bei Belastung durch Schnee läßt sich das Temperiermittel auch zum Erwärmen der Solarelemente einsetzen, so daß der auf dem Solarelement aufliegende Schnee abschmilzt, beziehungsweise auf einer geschmolzene Schneeschicht vom Solarelement herabgleitet. Auf diese Weise ist das gefährliche winterliche Abfegen der Solarelemente nicht länger nötig. Der gemeinsame Temperiermittelzulauf und -ablauf der Kanäle trägt ebenfalls zu einer effektiven Temperierung bei. Das Temperiermittel strömt dabei von dem in der üblichen geneigten Einbaulage der Solarelemente unten befindlichen Zulauf gleichzeitig durch alle parallelen Kanäle eines Solarelements zu dem in der geneigten Einbaulage oben befindlichen Ablauf, so dass sich ein homogenes Temperaturfeld erreichen lässt, das alle Solarzellen in gleichem Maße temperiert. Grundsätzlich ist auch ein einzelner, mäandrierender Hohlraum denkbar. Durch die Beabstandung der Kanäle voneinander ist die Anordnung einer Armierung zwischen diesen möglich, falls es aus statischen Gründen erforderlich ist, ohne die Bauhöhe des erfindungsgemäßen Solarelements unnötig zu vergrößern.

Schließlich ist erfindungsgemäß auch vorgesehen, dass der Rahmen wenigstens je eine, insbesondere jeweils gedichtete seitliche, Kontaktvorrichtung für eine elektrische und eine Temperiermittelverbindung zu einem weiteren Solarelement aufweist, wobei die elektrische Kontaktvorrichtung einen Kontakt zu sämtlichen Solarzellen eines Solarelements herstellend ausgebildet ist. Auf diese Weise lassen sich mehrere Rahmen einfach miteinander zu einem größeren System mit einem durchgehenden Temperiersystem verbinden, wobei das Temperiermittel durch das gesamte Solarelementsystem geführt wird. Es entfällt mit Vorteil die Notwendigkeit, zusätzliche Verdrahtungen zwischen einzelnen Rahmen vorzusehen. Es ist vielmehr möglich, alle Leitungen der Zellen eines Solarelements an der elektrischen Kontaktvorrichtung eines Rahmens zu bündeln und diesen an nur dieser einen Stelle mittels der elektrischen Kontaktvorrichtung an einen zweiten Rahmen anzuschließen. Auf diese Weise lassen sich die erfindungsgemäßen Rahmen ohne Werkzeug einfach zu einem größeren System verbinden. Wenn die Kontaktvorrichtungen gedichtet ausgebildet sind, ist sowohl ein Temperiermittelvedust ausgeschlossen, als auch ein schädigender Umwelteinfluß auf die elektrischen Leitungen, beispielsweise durch Feuchtigkeit.

Besteht der Rahmen aus Kunststoff, vorzugsweise aus einem verstärkten Kunststoff, insbesondere aus einem faserverstärktem oder armiertem Kunststoff, ganz insbesondere aus einem Polyurethan oder einem Acrylnitril-Butadien-Styrol-Copolymerisat, werden folgende Vorteile realisiert: Ein solcher Rahmen ist bei gleicher mechanischer Stabilität leichter als ein Metallrahmen. Für besonders schneelastgefährdete Einsatzorte ist erfindungsgemäß eine Faserverstärkung oder eine Armierung vorgesehen, so daß Lasten von bis zu 500 kg/m² Solarelementfläche bewältigt werden können. Der Kunststoffrahmen läßt sich über Herstellverfahren herstellen, die geringere Kosten als die metallener Rahmen verursachen, so daß geringere Gestehungskosten anfallen. Ein solcher Rahmen ist beispielsweise über Spritzgießverfahren herstellbar.

Die Verfahrensaufgabe der Erfindung wird dadurch gelöst, dass ein Herstellverfahren die Schritte umfasst:
Einlegen eines Formteils sowie gegebenenfalls wenigstens einer Armierung in ein Spritzgießwerkzeug,
Einlegen eines Solarzellenträgers, so dass der Solarzellenträger wenigstens teilweise auf dem Formteil aufliegt und
Spritzgießen eines gemeinsamen Rahmens um das Formteil, die gegebenenfalls wenigstens eine Armierung und den Solarzellenträger.

Zur Erfindung gehört ebenfalls ein Bausatz für eine Solarenergieanlage, bestehend aus mindestens zwei Solarelementen gemäß der oben geschilderten Merkmale, Montageschienen und Dachhaken. Ein solcher Bausatz erlaubt mit großem Vorteil eine schnelle, kostengünstige Montage eines effizienten Solarenergiesystems.

Zur Erfindung gehört ebenfalls die Verwendung eines Solarelements wie geschildert für eine Solarenergieanlage.

Schließlich gehört noch eine Solarenergieanlage zur Erfindung, die mindestens zwei Solarelemente wie geschildert umfasst, vorzugsweise jedoch bis zu 15.

Die Erfindung wird im Weiteren anhand der Figur einer Zeichnung erläutert, wobei
- Fig. 1: einen Schnitt durch einen erfindungsgemäßen Rahmen darstellt,
- Fig. 2: eine Skizze von drei zusammengesteckten Solarelementen in Einbaulage,
- Fig. 3a: eine geschnittene Aufsicht auf die miteinander verbundenen Kanäle und

Fig. 3b eine perspektivische Ansicht eines Detail von Kanal und Zulauf.

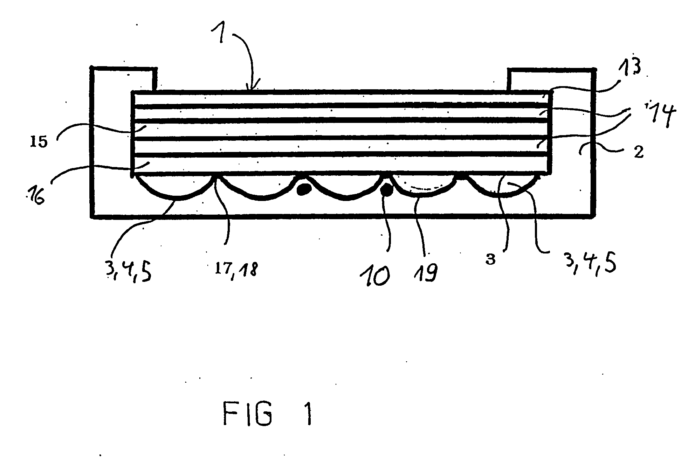

Fig. 1 zeigt ein erfindungsgemäßes Solarelement mit Solarzellenträger 1, Rahmen 2 und Temperiereinrichtung 3 im Querschnitt. Das Solarelement ist geschichtet aufgebaut, bestehend aus einer sonnennahen Glasschicht 13, einer EVA-Schicht 14 (Ethylenvinylacetat), der eigentlichen Solarzellenschicht 15, einer weiteren EVA-Schicht 14 sowie daran anschließend einer Schicht aus einer Kunststoffverbundfolie aus Polyvinylfluorid und Polyester (Tedlarschicht) 16. Der Rahmen 2 umgreift die Kanten des Solarzellenträgers 1, der mit seiner Rückseite auf einer Auflagefläche 17 des Rahmens 2 aufliegt. Die Auflagefläche 17 wird dabei durch eine tiefgezogene Platte 19 aus ABS (Acrylnitril-Butadien-Styrol-Copolymerisat) gebildet, in deren Oberfläche zueinander parallele halbzylindrische Kanäle 5 eingebracht sind. Diese Kanäle 5 werden durch den Solarzellenträger 1 abgeschlossen, so dass sich im einbaufertigen erfindungsgemäßen Solarelement aus den Kanälen 5 Hohlräume 4 ergeben, die miteinander verbunden sind. Diese Verbindung wird über einen in Fig. 1 nicht dargestellten rohrförmigen Zulauf 7 für Temperiermittel, hier Wasser, und einen ebenfalls nicht dargestellten rohrförmigen Ablauf 8 für Temperiermittel hergestellt. Erfindungsgemäß ist vorgesehen, dass vor allem Wasser ais Temperiermittel verwendet wird. Hierdurch erlaubt die Erfindung mit Vorteil auch die Erzeugung von warmem Wasser, da sich das zur Temperierung eingesetzte Wasser beim Durchlauf durch die erfindungsgemäßen Solarelemente erwärmt. Im Sommer stehen so größere Mengen umweltfreundlich erwärmten Wassers zur Verfügung, das auch als Brauchwasser verwendet werden kann. Wasser kann mittels einer einfachen Pumpe aus den Hausversorgungsleitungen durch die erfindungsgemäßen Solarelemente gefördert werden, es sind keine teuren und eventuell umweltschädlichen Kühlmittel erforderlich. Im Rahmen 2 sind Kontaktvorrichtungen 12 für das Temperiermittel vorgesehen, die seitlich, also orthogonal zu den Kanälen 5 angeordnet sind. Diese Kontaktvorrichtungen 12 sind beispielsweise nach Art von Kanalrohren ausgebildet, also mit ineinander steckbaren konischen Bereichen. Sowohl Zu- als auch Ablauf 7, 8 können gedichtet ausgebildet sein. Erfindungsgemäße Solarelemente lassen sich so leicht und dicht ineinander stecken und zu einer größeren Solarenergieanlage verbinden. Als Resultat ergibt sich eine Solarelementreihe, deren erstes Solarelement an eine Wasserleitung, eine Zisterne oder einen Brunnen angeschlossen ist und deren Zulauf 7 und Ablauf 8 jeweils mit dem nächsten Solarelement der Reihe verbunden sind. Die nichtbenötigten Öffnungen der Kontaktvorrichtungen des ersten und letzten Solarelements werden mit Deckeln reversibel dicht verschlossen. In Einbaulage der Solarelemente auf einem Dach befinden sich die Zuläufe 7 unten, so dass einlaufendes Wasser zunächst die Zuläufe 7 sämtlicher Solarelemente der Reihe füllt, anschließend durch die parallelen Kanäle 5 in etwa gleichem Maße nach oben zu den in Einbaulage oben angeordneten Abläufen 8 strömt und von dort über das letzte Solarelement in der Solarelementreihe im Sommer erwärmt und im Winter abgekühlt austritt und beispielsweise in ein Brauchwassersystem eingespeist wird. Zulauf 7 und Ablauf 8 sind dabei so dimensioniert, dass ihr Innenvolumen jeweils in etwa demjenigen der Summe aus sämtlichen Kanälen 5 entspricht. Zu einem bestimmten Zeitpunkt befindet sich daher etwa genauso viel Wasser im Zulauf 7, wie in den Kanälen 5 eines Solarelements, bzw. einer Solarelementreihe. Das in den Kanälen 5 strömende Wasser steht in Kontakt mit dem Solarzellenträger 1, da dieser eine Wand der Kanäle 5 bildet. Zwischen den Kanälen 5, die hier halbzylindrisch ausgebildet sind, jedoch auch jede andere geeignete Form annehmen können, weist die Platte 19 weiterhin Auflagestege 18 auf, auf denen der Solarelementträger 1 aufliegt. Diese Auflagestege 18 haben eine Breite von etwa 5 mm. Zwischen zwei Kanälen 5 ist, falls erforderlich, eine Armierung 10 in Form von Stahlstäben vorgesehen sein, die die mechanische Stabilität des erfindungsgemäßen Solarelements und der Kanalwandungen erhöht.

Neben den Kontaktvorrichtungen für Temperiermittel 12 ist eine Kontaktvorrichtung 11 für die elektrischen Leitungen vorgesehen. Erfindungsgemäß sind in dieser Kontaktvorrichtung alle Leitungen der einzelnen Solarzellen des Solarelements zusammengeführt. Diese Kontaktvorrichtung ist als männlicher/weiblicher Stecker ausgeführt, oder in jeder anderen, dem Fachmann bekannten Art und Weise benachbart zu den Kontaktvorrichtungen für Temperiermitteln 12 oder in diese integriert. Diese Kontaktvorrichtungen 11, 12 erlauben ein schnelles und sicheres Verbinden mehrerer erfindungsgemäßer Solarelemente mit möglichst wenigen Werkzeugen. Die so erzielte Solaranlagengröße kann jeder gewünschten Anforderung angepaßt werden.

Das erfindungsgemäße Solarelement ist nach Fertigung einstückig ausgebildet, Solarzellenträger 1 und Temperiereinrichtung 3 sind durch einen spritzgegossenen Rahmen 2 aus Kunststoff unlösbar miteinander verbunden. Als Kunststoff kommt hierbei insbesondere ABS in Betracht, dessen mechanische Eigenschaften den Anforderungen besonders gut entsprechen Es ist jedoch auch jeder andere Kunststoff verwendbar, der die erforderlichen mechanischen Eigenschaften aufweist. Zur Herstellung des erfindungsgemäßen Solarelements wird zunächst eine die Kanäle 5 tragende Platte 19 in geeigneter Weise in gewünschter Form und Größe hergestellt, beispielsweise durch Tiefziehen eines Kunststoffs. Für die Herstellung des Solarelements wird, falls erforderlich, eine Armierung 10 in ein Spritzgießwerkzeug eingelegt, gefolgt von der Platte 19 sowie einem aus bekannten Bauteilen zusammengesetztem, nicht laminiertem oder laminiertem Solarzellenträger 1. Im nächsten Schritt wird das Werkzeug geschlossen und der gewünschte Kunststoff eingespritzt, wobei die Kanten des Solarzellenträgers 1, die Armierung 10 und die Platte 19 mit einer gewissen Materialstärke umspritzt werden, so wie in Fig. 1 dargestellt. Falls statisch möglich, wird nicht die gesamte Platte 19 umspritzt, sondern nur der Bereich zwischen zwei Kanälen mit dort eingelegter Armierung 10 und der seitliche, den Solarzellenträger 1 umgreifende Bereich. In diesem Fall wäre ein Teil der Platte 19 eines fertigen Solarelements sichtbar.

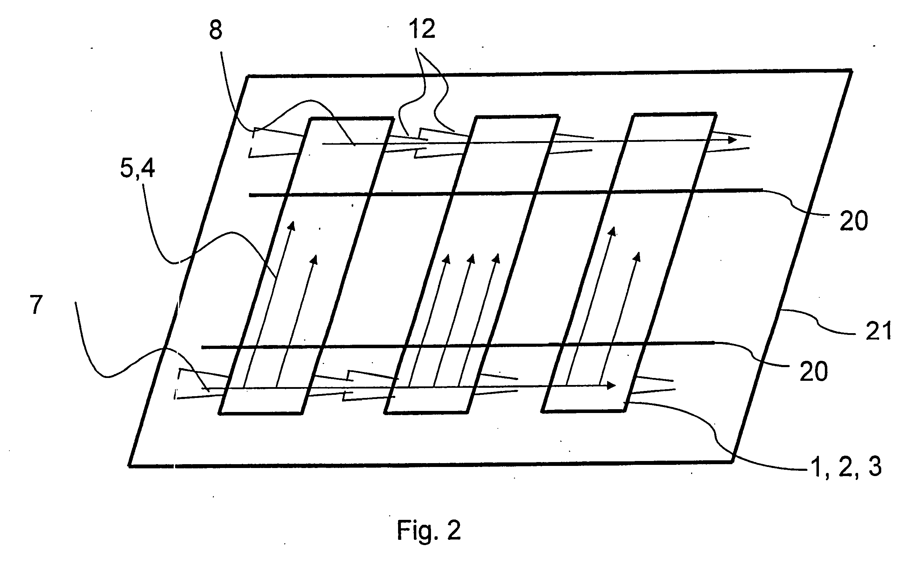

Fig.2 zeigt eine teilweise geschnittene Skizze von drei erfindungsgemäßen Solarelementen in Einbaulage auf einem Dach 21 befestigt über Montageschienen 20. Skizzenhaft angedeutet sind die Temperiermittelverbindungen 12 sowie der Temperiermittelstrom in den Kanälen 5. Der Zulauf des Wassers erfolgt für alle drei Solarelemente im unteren Bereich. Aufgrund des in der Hauswasserleitung vorhandenen oder durch eine Pumpe erzeugten Drucks steigt das Wasser in den Kanälen 5 nach oben zu einem allen Kanälen gemeinsamen, durchgehenden Ablaufkanal 8 und von dort in einen nicht dargestellten Ablauf oder Brauchwassertank. Das so unterhalb der Solarzellen erzeugte, homogene Temperaturfeld verbessert deren Effizienz. Die elektrischen Verbindungen sind nicht dargestellt, sie befinden sich unmittelbar benachbart zu den Temperiermittelverbindungen 12, um den konstruktiven Aufwand und das Ineinanderstecken der Verbindungen beim Erstellen einer Solarelementreihe möglichst einfach zu gestalten.

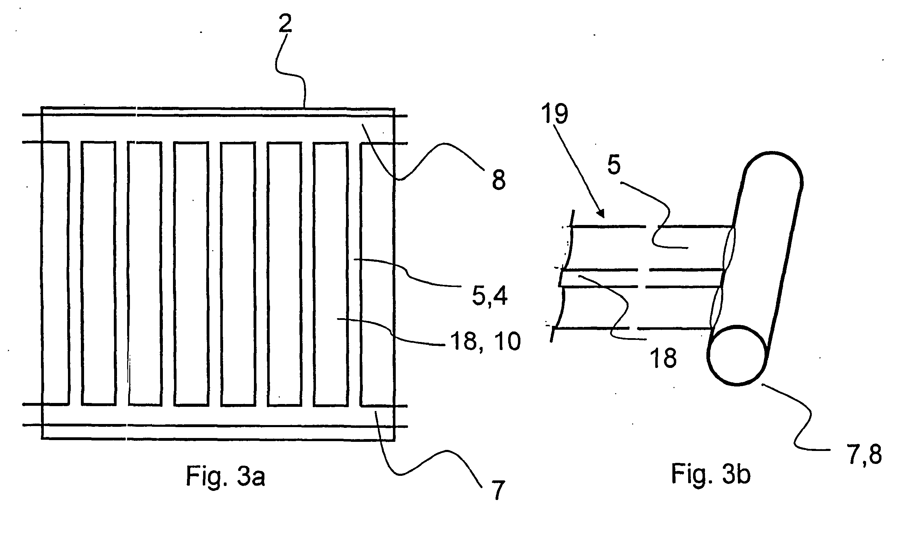

Fig. 3a zeigt eine skizzenhafte Aufsicht auf das Kanalsystem 5 eines Solarelements mit Zu- und Ablauf (7, 8) ohne Temperiermittelanschlüsse 12. Die Aufsicht liegt dabei in der Ebene direkt unterhalb des Solarzellenträgers 1. Zwischen den halbzylindrischen Kanälen 5 befinden sich Auflagestege 18, und gebenenfalls darunter angeordnete Armierungen 10. Zulauf 7 und Ablauf 8 können mit benachbarten Solarelementen verbunden werden.

Fig. 3b zeigt ein Detail aus der Verbindung von Zulauf 7 und Kanal 5. Der Zulauf 7 ist als seitlich in Abständen geöffnetes Rohr ausgebildet, wobei die Kanäle 5 in einer Platte 19 als etwa halbierte Rohre ausgebildet sind, deren Längsöffnung nach oben, zu einem nicht dargestellten Solarzellenträger 1 weisen. Das Volumen des Rohres 7, 8 entspricht in etwa demjenigen der Summe aller Kanäle 5 einer Platte 19.

### BEZUGSZEICHENLISTE

- 1.: Solarzellenträger
- 2.: Rahmen
- 3.: Temperiereinrichtung
- 4.: Hohlraum
- 5.: Kanal
- 6.: Stirnseite
- 7.: Zulauf
- 8.: Ablauf
- 9.: Formteil
- 10.: Armierung
- 11.: elektrische Verbindung
- 12.: Temperiermittelverbindung
- 13.: Glasschicht
- 14.: EVA-Schicht
- 15.: Tedlar-Schicht
- 16.: Solarzellen
- 17.: Auflagefläche
- 18.: Auflagestege
- 19.: Platte
- 20.: Montageschiene
- 21.: Dach

## Patentansprüche

1. Solarelement bestehend aus Solarzellenträger (1), Rahmen (2) und Temperiereinrichtung (3), wobei der Rahmen (2) wenigstens eine sonnenabgewandte Seite des Solarelements überdeckend ausgebildet ist und wobei die Temperlerelnrichtung (3) integraler Bestandteil des Rahmens (2) ist, und wobei die Temperiereinrichtung (3) mehrere, miteinander verbundene Hohlräume (4) aufweist, wobei die Hohlräume (4) als voneinander beabstandete, miteinander verbundene Kanäle (5) ausgebildet sind und die mit ihrer offenen Seite an den Solarzellenträger (1) grenzend ausgebildet sind, **dadurch gekennzeichnet, dass** die Kanäle (5) überwiegend parallel ausgebildet sind und an ihren Stirnseiten (6) über einen Zulauf (7) und einen Ablauf (8) miteinander verbunden ausgebildet sind und dass die Kanäle (5) aus wenigstens einem Formteil (9), insbesondere Kunststoffformteil, gebildet sind und wobei der Rahmen (2) Armierungen (10) aufweist, vorzugsweise stabförmige Stahlarmierungen, die in überwiegend paralleler Richtung zu den Kanälen (5) zwischen diesen angeordnet sind und wobei Solarzellenträger (1), Rahmen (2) und Temperiereinrichtung (3) einstückig ausgebildet sind.

2. Solarelement gemäß Anspruch 1 **dadurch gekennzeichnet, dass** der Rahmen (2) wenigstens je eine, insbesondere jeweils gedichtete seitliche, Kontaktvorrichtung für eine elektrische (11) und eine Temperlermittelverbindung (12) zu einem weiteren Solarelement aufweist, wobei die elektrische Kontaktvorrichtung (11) einen Kontakt zu sämtlichen Solarzellen eines Solarelements herstellend ausgebildet ist.

3. Solarelement gemäß Anspruch 1 oder 2, **dadurch gekennzeichnet, dass** der Rahmen (2) aus Kunststoff besteht, vorzugsweise aus einem verstärkten Kunststoff, insbesondere aus einem faserverstärktem oder armiertem Kunststoff, ganz insbesondere aus einem Polyurethan oder einem Acrylnitril-Butadien-Styrol-Copolymerisat.

4. Solarelement gemäß einem der vorherigen Ansprüche, **dadurch gekennzeichnet, dass** der Rahmen (2) mittels Spritzgießens herstellbar ist.

5. Verfahren zur Herstellung eines Solarelemente nach Anspruch 1, mit den Schritten:
a) Einlegen eines Formteils (9) sowie gegebenenfalls wenigstens einer Armierung (10) in ein Spritzgießwerkzeug,
b) Einlegen eines Solarzellenträgers, so dass der Solarzellenträger wenigstens teilweise auf dem Formteil (9) aufliegt und
c) Spritzgießen eines gemeinsamen Rahmens (2) um das Formteil (9), die gegebenenfalls wenigstens eine Armierung (10) und den Solarzellenträger (1).

6. Bausatz für eine Solarenergieanlage, bestehend aus mindestens zwei Solarelementen gemäß einem der Ansprüche 1 bis 4, Montageschienen und Dachhaken.

7. Verwendung eines Solarelements gemäß einem der Ansprüche 1 bis 4 für eine Solarenergieanlage.

8. Solarenergieanlage, umfassend mindestens zwei Solarelemente gemäß einem der Ansprüche 1 bis 4, vorzugsweise 15 Solarelemente.

## Claims

1. A solar element comprising a solar array (1), a frame (2) and a temperature regulation device (3), wherein the frame (2) is constructed so as to overlay at least a side of the solar element facing away from the sun, and wherein the temperature regulation device (3) is an integral component of the frame (2), and wherein the temperature regulation device (3) comprises a plurality of cavities (4) that are connected to each other, wherein the cavities (4) are constructed as canals (5) that are connected with but at a distance from each other and are constructed such that the open side thereof borders the solar array (1), **characterized in that** the canals (5) are constructed mostly parallel to each other and are designed so as to be connected with each other at their end faces (6) via an infeed (7) and an outfeed (8), and that the canals (5) are made from at least one moulded part (9), particularly a plastic moulded part, and wherein the frame (2) has reinforcements (10), preferably rod-shaped steel reinforcements, which are disposed mostly parallel to the channels (5) that pass between them, and wherein the solar array (1), the frame (2) and the temperature regulation device (3) are constructed as a single unit.

2. The solar element according to claim 1, **characterized in that** the frame (2) has at least one, particularly individually sealed lateral contact device for each of an electrical (11) and a temperature regulation device connection (12) with a further solar element, wherein the electrical contact device (11) is constructed so as to create a contact with all solar cells in a solar element.

3. The solar element according to claim 1 or 2, **characterized in that** the frame (2) is made from plastic, preferably a reinforced plastic, particularly a fibre-reinforced or armoured plastic, most particularly from a polyurethane or an acrylonitrile butadiene styrene copolymerisate.

4. The solar element according to any of the preceding claims, **characterized in that** the frame (2) is producible by injection moulding.

5. A method for producing a solar element according to claim 1, comprising the steps
a) inserting a moulded part (9) and optionally at least one reinforcement (10) in an injection mould
b) inserting a solar array in such manner that at least part of the solar array rests on the moulded part (9), and
c) injection moulding a joint frame (2) around the moulded part (9), the optional at least one reinforcement (10) and the solar array (1).

6. A construction kit for a solar energy installation, comprising at least two solar elements according to any of claims 1 to 4, mounting rails and roof hooks.

7. Use of a solar element according to any of claims 1 to 4 for a solar energy installation.

8. A solar energy installation comprising at least two solar elements according to any of claims 1 to 4, preferably 15 solar elements.

## Revendications

1. Elément solaire constitué d'un support de cellule solaire (1), un châssis (2) et un dispositif de climatisation (3), dans lequel le châssis (2) est relié de manière à recouvrir au moins un côté qui se détourne du soleil de l'élément solaire et dans lequel le dispositif de climatisation (3) est partie intégrante du châssis (2), et dans lequel le dispositif de climatisation (3) présente plusieurs espaces creux (4) reliés les uns aux autres, dans lequel les espaces creux (4) sont réalisés comme des canaux (5) reliés et espacés les uns des autres et qui sont réalisés de manière à affleurer par leur côté ouvert sur le support de cellule solaire (1), **caractérisé en ce que** les canaux (5) sont réalisés principalement en parallèle et son reliés les uns aux autres sur leurs côtés frontaux (6) par l'intermédiaire d'une conduite d'amenée (7) et d'une conduite évacuation (8) et **en ce que** les canaux (5) sont formés d'au moins une pièce façonnée (9), notamment une pièce façonnée en plastique, et dans lequel le châssis (2) présente des armatures (10), de préférence des armatures en acier en forme de barre, qui sont disposés dans une direction essentiellement parallèle aux canaux (5) entre ceux-ci et dans lequel le support de cellule solaire (1), le châssis (2) et le dispositif de climatisation (3) sont réalisés en un seul tenant.

2. Elément solaire selon la revendication 1, **caractérisé en ce que** le châssis (2) présente au moins un dispositif de contact latéral notamment respectivement étanche destiné à une liaison électrique (11) et une liaison de moyen de climatisation (12) à un autre élément solaire, dans lequel le dispositif de contact électrique (11) est réalisé de manière à produire un contact avec toutes les cellules solaires d'un élément solaire.

3. Elément solaire selon les revendications 1 ou 2, **caractérisé en ce que** le châssis (2) est constitué de plastique, de préférence d'un plastique renforcé, notamment d'un plastique à armature ou renforcé par des fibres, notamment d'un polyuréthane ou d'un copolymérisat styrol-butadiène-acrylonitrile.

4. Elément solaire selon une des revendications précédentes, **caractérisé en ce que** le châssis (2) peut être fabriqué au moyen d'un moulage par injection.

5. Procédé de fabrication d'un élément solaire selon la revendication 1, avec les étapes consistant à :
a) placer une pièce façonnée (9) ainsi que le cas échéant au moins une armature (10) dans un outil de moulage par injection,
b) placer un support de cellule solaire, de telle sorte que le support de cellule solaire vienne reposer au moins partiellement sur la pièce façonnée (9) et
c) mouler par injection un châssis commun (2) autour de la pièce façonnée (9), qui le cas échéant présente au moins une armature (10) et le support de cellule solaire (1).

6. Kit de montage d'une installation d'énergie solaire, constituée d'au moins deux éléments solaires selon une des revendications 1 à 4, des rails de montage et des crochets de toit.

7. Utilisation d'un élément solaire selon une des revendications 1 à 4 pour une installation d'énergie solaire.

8. Installation d'énergie solaire, comprenant au moins deux éléments solaires selon une des revendications 1 à 4, de préférence 15 éléments solaires.
